(19) **Europäisches Patentamt / European Patent Office / Office européen des brevets**

(11) **EP 2 476 005 B1**

(12) **EUROPEAN PATENT SPECIFICATION**

(45) Date of publication and mention
of the grant of the patent:
**26.06.2013  Bulletin 2013/26**

(21) Application number: **09782825.5**

(22) Date of filing: **09.09.2009**

(51) Int Cl.:
***G01R 33/035*** (2006.01)

(86) International application number:
**PCT/EP2009/061699**

(87) International publication number:
**WO 2011/029471 (17.03.2011 Gazette 2011/11)**

(54) **SQUID WITH A COIL INDUCTIVELY COUPLED TO THE SQUID VIA A MUTUAL INDUCTANCE**

SQUID MIT EINER ÜBER GEGENSEITIGE INDUKTANZ AN DEN SQUID GEKOPPELTEN SPULE

SQUID COMPORTANT UNE BOBINE COUPLÉE INDUCTIVEMENT AU SQUID PAR UNE INDUCTANCE MUTUELLE

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(43) Date of publication of application:
**18.07.2012  Bulletin 2012/29**

(73) Proprietors:
- **Forschungszentrum Jülich GmbH**
  **52425 Jülich (DE)**
- **Shanghai Institute of Microsystem and Information**
  **Technology (SIMIT), Chinese Academy of Sciences**
  **(CAS)**
  **Shanghai,**
  **200050 (CN)**

(72) Inventors:
- **ZHANG, Yi**
  **52428 Jülich (DE)**
- **KRAUSE, Hans-Joachim**
  **52499 Baesweiler (DE)**
- **WOLTERS, Norbert**
  **52134 Herzogenrath (DE)**
- **OFFENHÄUSSER, Andreas**
  **B-4731 Eynatten (BE)**
- **XIE, Xiaoming**
  **Shanghai 200050 (CN)**
- **WANG, Huiwu**
  **Shanghai 200050 (CN)**
- **WANG, Yongliang**
  **Shanghai 200050 (CN)**
- **DONG, Hui**
  **Shanghai 200050 (CN)**

(74) Representative: **Gille Hrabal**
**Patentanwälte**
**Brucknerstrasse 20**
**40593 Düsseldorf (DE)**

(56) References cited:
**JP-A- 7 318 623     JP-A- 8 146 109**

- **"Low noise YBa2Cu3O7-x SQUID magnetometers operated with additional positive feedback" APPLIED PHYSICS LETTERS, AIP, AMERICAN INSTITUTE OF PHYSICS, MELVILLE, NY, US LNKD- DOI:10.1063/1.116036, vol. 68, no. 13, 25 March 1996 (1996-03-25), pages 1856-1858, XP012014935 ISSN: 0003-6951 cited in the application**
- **MIKKO KIVIRANTA: "SQUID linearization by current-sampling feedback" SUPERCONDUCTOR SCIENCE AND TECHNOLOGY, IOP PUBLISHING, TECHNO HOUSE, BRISTOL, GB, vol. 21, no. 4, 1 April 2008 (2008-04-01), page 45009, XP020135266 ISSN: 0953-2048**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The invention relates to a dc-SQUID with a connected coil which is inductively coupled to the SQUID via a mutual inductance.

The Superconducting Quantum Interference Device (SQUID) is an extremely sensitive sensor, which can be used to detect the magnetic flux, or any physical quantities that can be converted into magnetic flux. A "dc-SQUID", which is biased to a direct current power supply, consists of a superconducting loop that is interrupted by two (identical) Josephson junctions. The output signals of SQUID can be detected with the help of readout electronics. The main design difficulty is to amplify the very small output signals without introducing a noise contribution from the preamplifier.

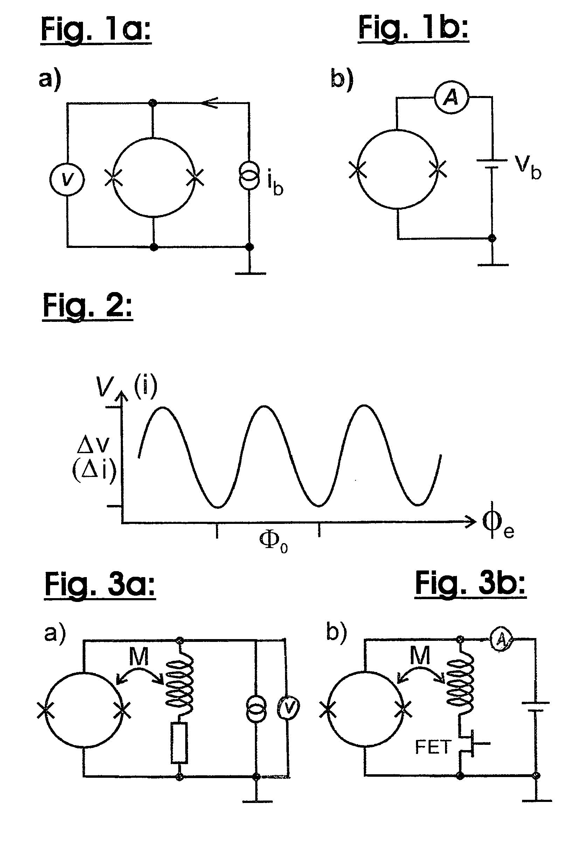

Two different ways to bias a dc-SQUID, the current bias and the voltage bias, are depicted in **Fig. 1**. In the current bias mode (**Fig. 1a**), a constant current, generated by an ideal current source, is passed through the SQUID, and a voltage across it changes periodically with the external magnetic flux (**Fig. 2**). Similarly, if a constant voltage caused by an ideal voltage source is applied across the SQUID (**Fig. 1b**), the current through SQUID is also periodically modulated by the external magnetic flux (**see Fig. 2**). Here, the SQUID acts as a flux-to-voltage or a flux-to-current converter in these two bias modes, respectively. The period of the V-$\Phi$ (I-$\Phi$) characteristics is a flux quantum ($\Phi_0 = 2.07 \times 10^{-15}$ Wb.

Commonly, the contribution of preamplifier noise is much higher than that of the intrinsic SQUID noise. The preamplifier introduces two extra noise sources: a current noise source and a voltage noise source. Usually, the contribution of the preamplifier current noise is much lower than that of its voltage noise. The typical value of the voltage noise is 1 nV/$\sqrt{\text{Hz}}$. Both in current and voltage bias mode, the preamplifier noise contributions are usually higher than the intrinsic SQUID noise. Therefore, the optimal SQUID readout design requires to readout the SQUID signals without adding preamplifier noise.

Presently, there have been a number of approaches to suppress the preamplifier noise.

1. Transformer and flux modulation
R. L. Forgacs et al., "Digital-analog magnetometer utilizing superconducting sensor", Rev. Sci. Instrum. 38, 214-220 (1967), firstly employed a step-up transformer, modulation flux and lock-in detector, thus the external flux could be sensed by synchronously detecting the SQUID voltage at the modulation frequency.

2. Two-stage configuration
Another feasible technique is to use a second SQUID as a low-noise preamplifier. There are several possibilities for the choice of the amplifier SQUID: SQUIDs with bare (hysteretic) junctions operated either in analog (M. Gershenson, "Design of a hysteretic SQUID as the readout for a dc-SQUID", IEEE Trans. Magn. 27, 2910-2912 (1991) and M. Podt et al., "Two-stage amplifier based on a double relaxation oscillation superconducting quantum interference device", Appl. Phys. Lett. 75, 2316-2318 (1999)) or in digital mode (D. Drung et al., "Measured performance parameters of gradiometers with digital output", IEEE trans.Magn. 25, 1034-1037 (1989)), and SQUIDs with resistively shunted junctions which are read out with flux modulation (F. C. Wellstood et al., "Low-frequency noise in dc superconducting quantum interference devices below 1 K", Appl. Phys. Lett. 50, 772-774 (1987)), or directly (V. Foglietti, "Double dc-SQUID for flux-locked-loop operation", Appl. Phys. Lett 59, 476-478 (1991) and Maslennikov et al., "A double dc-SQUID based magnetometer", IEEE Trans. Appl. Supercond. 5, 3241-3243 (1995)), or with series SQUID arrays (R. P. Welty et al., "Two-stage integrated SQUID amplifer with series array output", IEEE Trans. Appl. Supercond. 3, 2605-2608 (1993)).

3. Series SQUID arrays
In the work of R. P. Welty et al., "A series array of dc-SQUIDs", IEEE Trans. Magn. 27, 2924-2926 (1991), numerous identical SQUIDs were connected in series to add up the small output signals of single detecting SQUID.

4. Relaxation Oscillation SQUIDs
The so-called relaxation oscillation SQUIDs (ROS) can also obtain high transfer coefficient by using a dc-SQUID in series with hysteretic junctions, which is shunted by a resistance and an inductance (F.L. Vernon et al., "Relaxation oscillations in Josephson junctions", J. Appl. Phys. 39, 2661-2664 (1968)). If two hysteretic junctions are connected in series and shunted by a resistance and an inductance, a double relaxation oscillation SQUID (DROS) is achieved.
D. J. Adelerhof et al., "(Double) relaxation oscillation SQUIDs with high flux-to-voltage transfer: simulations and experiments", J. Appl. Phys. 76, 3875-3886 (1994)) presented that in this case, a step-like V-$\Phi$ characteristics led to an extremely high transfer coefficient.

All these above mentioned techniques are somewhat bulky or complex, such as the transformer in flux modulation scheme or more than one SQUID needed in the two-stage configuration. Large series SQUID arrays suffer from parasitic resonances in the input coils and their V-$\Phi$ characteristics may be distorted by variations in the bias of the individual SQUIDs. The ROS and DROS need more than four or five wires per independent unit, respectively, to connect the cold region with the room temperature electronics, thus inevitably leading to large thermal losses.

The following two methods are considered to be the closest background arts related to the present invention:

- The Additional Positive Feedback (APF), disclosed by D. Drung et al., "Low-noise high-speed dc superconducting quantum interference device magnetometer with simplified feedback electronics", Appl. Phys. Lett. 57, 406-408 (1990), comprises an additional circuit containing a resistance and a coil in series which is connected to SQUID in parallel (shown in **Fig. 3a**), and operates in current bias mode.. The coil is inductively coupled to the SQUID via a mutual inductance. This additional circuit causes positive feedback, so that the SQUID transfer coefficient $\partial V/\partial\Phi$ on one slope is strongly enhanced. If one sets the working point at the steepest slope of the V-$\Phi$ characteristic, the maximal transfer coefficient $\partial V/\partial\Phi$ is achieved, so that the equivalent preamplifier flux noise is reduced.

APF includes that the peak-to-peak voltage swing is reduced due to the APF resistance which acts as an extra shunt at low frequencies. Furthermore, the reduced linear range of the V-F characteristics with APF is unfavorable for the system slew rate and makes it more difficult to apply bias reversal. Finally, the introduction of the APF resistance affects the total noise contribution (D. Drung, Supercond. Sci. Technol. 16, 1320-1336 (2003)).

JP-A 0 7318623 and JP-A 08 146109 each disclose APF Sensors for detecting the magnetic flux, comprising a SQUID (Direct-Current Superconducting Quantum Interference Device) and a feedback coil electrically connected with a first side of the SQUID and being inductively coupled to the SQUID via a mutual inductance, whereby the SQUID is biased by an ideal current source.

- The Noise Cancellation (NC) comprises a FET and a coil and operates in voltage bias mode: using a quite similar circuit in voltage bias mode, M. Kiviranta et al., "DC-SQUID electronics based on the noise cancellation scheme", IEEE Trans. Appl. Supercond. 5, 2146-2148 (1995), teaches that by replacing the APF resistance with a cooled voltage-controlled GaAs FET (**Fig. 3b**), this additional circuit can cancel the voltage noise of preamplifier, which is also called noise cancellation method (NC).

NC: In order to suppress the amplifier noise contribution, a NC condition should be met: $R_{FET}=M\cdot\partial V/\partial\Phi$. Therefore, an adaptive gain control is necessary for the system to tolerate variations in fabrication parameters, bath temperature fluctuations, rf interferences, etc. It is also important to find methods to eliminate the extra flux noise caused by the drift in the critical currents, drift in the feedback resistor, the flux variation caused by the gain control circuit, etc. On the other hand, the cooled active device (FET) also increases the noise level, so a low noise SQUID requires a FET with a low channel resistance. But FETs with a high input capacitance and a low channel resistance are difficult to find because most of the GaAs FETS are intended for high frequency applications [H. Seppä et al., IEEE Trans. Magn. 27, 2488-2490 (1991)].

MIKKO KIVIRANTA: "SQUID linearization by current-sampling feedback", Superconductor Science and Technology, IOP Publishing, Techno House; Bristol, GB, vol. 21 , no. 4, 1 April 2008, page 45009, XP0201 35266ISSN: 0953-2048 discloses a sensor for detecting the magnetic flux, comprising a Direct-Current Superconducting Quantum Interference Device and a feedback being inductively coupled to the SQUID via a mutual inductance.

The object of the present invention is to reduce in an inartificial and compact manner preamplifier noise of a sensor for detecting magnetic flux comprising a SQUID and a feedback coil electrically connected to the SQUID.

This object is achieved by a sensor for detecting magnetic flux comprising the features of claim 1. Advantageous features are subject matter of the depending claims.

According to the present invention the advantages of an additional positive feed back coil (APF) and noise cancellation technique with a SQUID bootstrap circuit comprising an APF in series at constant voltage bios of the SQUID are combined.

The SQUID Bootstrap Circuit (SBC) consists of a mutually coupled dc-SQUID and a feedback coil. The SQUID and the coil are connected in series. They are inductively coupled with a mutual inductance. The feedback coil, which can be made of a superconductor or of a normal metal, can be either integrated on the SQUID chip, or be placed separately next to the SQUID. Together, both SQUID and coil form a novel two-terminal device, which will be named SBC. The invention combines the advantages of both, APF and NC, and avoids certain drawbacks thereof.

The novel two-terminal device called (SBC) consists of a mutually coupled dc-SQUID and a feedback coil. With the help of this new design, the current or voltage -$\Phi$ characteristics of SQUID will be asymmetric and the equivalent dynamic resistance will be changed. SBC can be regarded as a novel circuit element. In this invention, the novel two-terminal device SBC can make the I-$\Phi$ periodic characteristics asymmetric and change the dynamic resistance of SQUID.

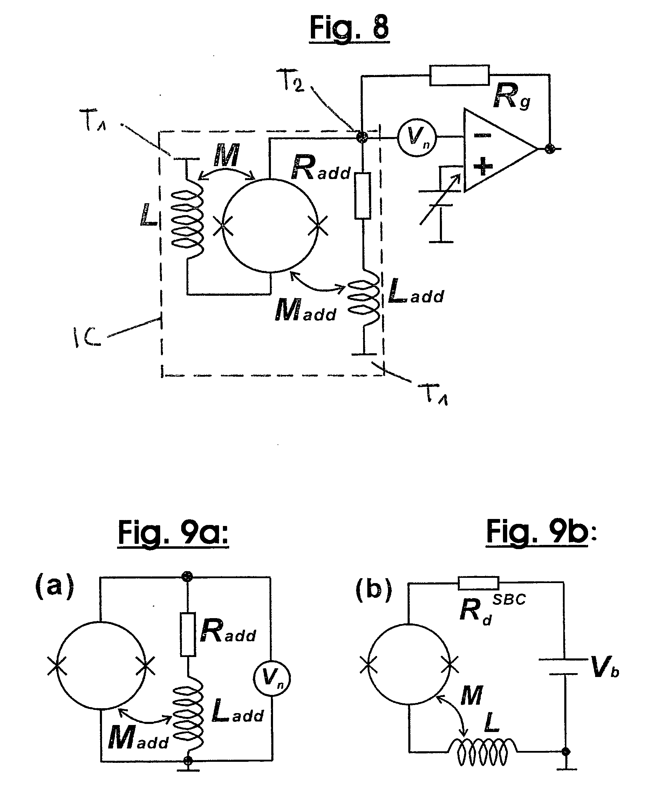

The output signals of SQUID can be detected/amplified with the help of readout electronics. The main design difficulty is to amplify the very small output signals without introducing a noise contribution from the preamplifier. If the input circuit of voltage biased SBC is provided with two different equivalent dynamic resistances, it is possible to increase $(\partial i/\partial\Phi)_{SBC}$ and suppress the preamplifier noise at the same time, so that one may obtain a high SNR improvement. This will be further explained under **Fig. 8**.

In one embodiment the coil comprises a superconductor material as conductor, in particular a wire made of the same in order to reduce the thermal noise and the eddy current noise. The coil may comprise a normal metal material, for example copper, as conductor, in particular a wire made of the same if suitable in order to reduce costs. The invention and its embodiments will be further explained by means of the following description and drawings, which enables better understanding of the objectives, features, functions and advantages of the invention. It shows:

**Fig. 1:**        a SQUID readout principle. (Fig. 1 a) current bias, (Fig. 1b) voltage bias;

**Fig. 2:**        the resulting V(I) - Φ characteristics of the SQUID of Fig 1;

**Fig. 3:**        the equivalent circuits of (Fig. 3a) APF and (Fig. 3b) NC;

**Fig. 4a and 4b:**        the SBC equivalent circuits in two bias modes;

**Fig. 5a:**        a I(V)-Φ curve of SBC being asymmetric because of the mutual inductance **5**;

**Fig. 5b:**        a measured I-Φ curve of SBC in the voltage bias mode under the condition $M \cdot (\partial i / \partial \Phi) \approx 1$

**Fig. 6:**        a measured I-V curve without and with mutual inductance **5** in the current bias mode at two different sides of the V-Φ curve;

**Fig. 7:**        a measured I-V curve without and with mutual inductance **5** in the voltage bias mode at two different sides of the I-Φ curve;

**Fig. 8:**        an input circuit of voltage biased SBC with two different equivalent dynamic resistances;

**Fig. 9a and 9b:**        the equivalent circuits of Fig. 8 for preamplifier noise and external flux signal, respectively;

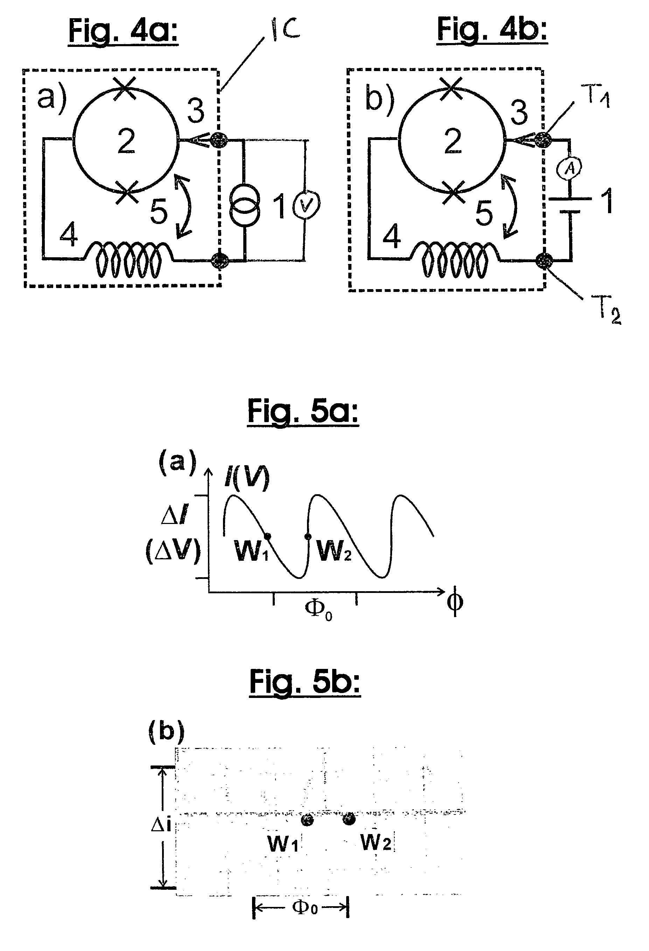

The equivalent circuit of SBC is shown in **Fig. 4**: The dc-SQUID **2** is biased by an ideal current source (**Fig. 4a**) or voltage source (**Fig. 4b**) **1**. In the current bias mode, the current **3** through the SQUID **2** and the feedback coil **4** connected in series is constant however the voltage across the SQUID **2** is modulated as the external magnetic field is changed. In the voltage bias mode according to the invention, the SQUID **2** is biased with a constant voltage and the current **3** is modulated by the external field. The feedback coil **4** is inductively coupled to the SQUID **2** via a mutual inductance **5**, so an additional flux appears in the SQUID loop. The arrangement sequence of the SQUID **2** and feedback coil **4** can be exchanged.

The new element (SBC) has the following special characteristics:

Both in the current - and voltage -bias modes, the voltage (current)-flux curves (**Fig. 5a**) and the current-voltage curves become asymmetric. Taking the voltage bias mode for example, the flux in the SQUID-loop $\phi_{Loop}$ consists of two parts, the external magnetic flux $\Delta \phi_e$ and the additional feedback flux $\Delta \phi_a$ generated by the product of the current change and the mutual inductance $M$. Then the I-Φ characteristics becomes asymmetric. When the slope $\partial I / \partial \Phi$ is positive, the total flux in the loop is changed by the difference of the external and the additional flux, $\Delta \phi_{Loop} = \Delta \phi_e - \Delta \phi_a$. In case of the negative slope $\partial I / \partial \Phi$, the total flux change is given by the sum, $\Delta \phi_{Loop} = \Delta \phi_e + \Delta \phi_a$. These relations can be reversed when the polarity of $L$ is changed. The product of $\Delta i \cdot M$ determines the asymmetry of the I-Φ characteristics. The current-to-flux transfer coefficient of SBC is expressed as

$$(\partial i / \partial \Phi)_{SBC} = (\partial i / \partial \Phi)/(1 - M \cdot \partial i / \partial \Phi),$$

in which $\partial I / \partial \Phi$ is the current-to-flux transfer coefficient of a bare (original) SQUID without $L$ and

$$M^2 = k^2(Ls \cdot L)$$

with $k$ being the coupling coefficient between SQUID and coil; $L$ being the inductance of the feedback coil and $Ls$ being the inductance of the SQUID.

If the sensor is so designed that the value of the expression $M \cdot \partial I / \partial \Phi$ is between 0 and 1, the I(V)-Φ curve of SBC is asymmetric while the inventive advantages are obtained. Preferably a value of the expression is between 0.5 and 1, and more preferably between 0.84 and 0.96 is obtained.

The dynamic resistances of SBC ($R_d{}^{SBC}$) are also changed because of the feedback flux coupled via M in the constant bias voltage. The dynamic resistance denotes the slope of the V-I curve or (as in our case) the inverted slope of the I-V curve at the working point of the SQUID. The working point, $W_1$ or $W_2$, determines the value of the dynamic resistance. The dynamic resistance of SBC can be expressed as $R_d{}^{SBC} = R_d(1 - M \cdot \partial i / \partial \Phi)$, where $R_d$ is the dynamic resistance of a bare SQUID without $L$ in series. **Fig. 5b** shows a measured I-$\Phi$ curve of SBC in the voltage bias mode under the condition $M\cdot(\partial I/\partial \Phi) \approx 1$. When the working point of SBC is selected at the gradual side of the I-$\Phi$ characteristics ($W_1$ in **Fig. 5b**), $\partial I/\partial \Phi$ is negative and $R_d^{SBC(W1)}$ is larger than $R_d$. Similarly, if the working point is set at the steep side, $R_d^{SBC(W2)}$ is decreased.

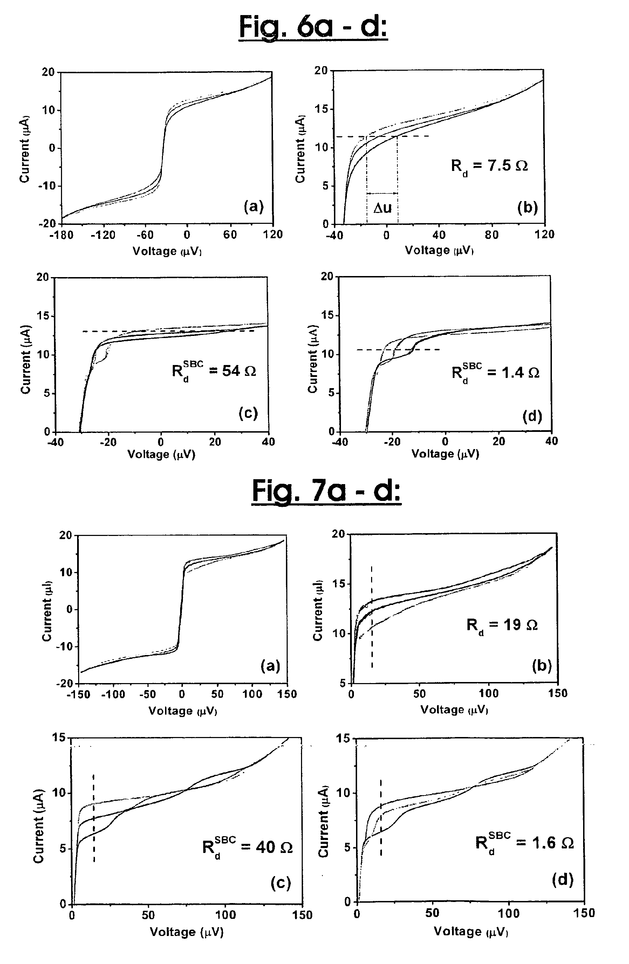

**Fig. 6a** is the current-voltage characteristics of the dc-SQUID without the coil **4** when the magnetic flux is changed from n $\Phi_0$ to (n+1/2) $\Phi_0$ in the current bias ($I_b$) mode. When the positive section is enlarged in **Fig. 6b**, for the bias current is constant, it is clearly seen that the largest voltage changing range of this SQUID is about 20 $\mu$V. In this case $R_d$ is 7.5 $\Omega$. However, in SBC, the voltage changing range is significantly increased to 50 $\mu$V (see **Fig. 5c**) at the steep slope side (see **Fig. 5b**), resulting in $R_d^{SBC}$ of 54 $\Omega$. In contrast, $R_d^{SBC}$ is decreased to only 1.4 $\Omega$ at the gradual slope side of **Fig. 5b**.

Comparing **Fig. 6b** and **Fig. 6c** one can find that the maximal voltage dynamic or changing range $\Delta$U, i.e. the signal peak-to-peak amplitude, is increased from about 20 $\mu$V to 50 $\mu$V after the introduction of the inductance L in series.

In the voltage bias mode, the current changing range is almost not varied without and with mutual inductance **5**. **Fig. 7a** is the current-voltage characteristics of the dc-SQUID without the coil **4** when the magnetic flux is changed from n $\Phi_0$ to (n+1/2) $\Phi_0$ in the voltage bias ($U_b$) mode. From the enlarged section (**Fig. 7b**), the original $R_d$ of 19 $\Omega$ is obtained. When the working point is chosen at the gradual side of current-flux characteristics in **Fig. 5b**, $R_d^{SBC}$ of SBC is also increased to 40 $\Omega$ (**Fig. 7c**). But like the current bias mode, $R_d^{SBC}$ at the other side is decreased to only 1.6 $\Omega$.

When connecting readout electronics, for example an OP, the output signals of the SQUID can be detected and amplified. The main design difficulty is to amplify the very small output signals without introducing a noise contribution from the preamplifier. This can be obtained by a Voltage biased SBC with two different equivalent dynamic resistances, which will be explained under **Fig. 8**. One path comprising $L_{add}$ and $R_{add}$ is used to reduce the preamplifier noise and the other path L is for increasing $\partial i/\partial \Phi$ and therefore the external flux signal.

The readout electronic circuit comprises as preamplifier an usual OP which is being configured by a resistance $R_g$ and a variable voltage bias source to operate as a current-voltage-converter.

According to the expression of $(\partial i/\partial \Phi)_{SBC} = (\partial i/\partial \Phi)/(1-M\cdot\partial i/\partial \Phi)$ and $R_d^{SBC}=R_d(1-M\cdot\partial i/\partial \Phi)$, the $\partial i/\partial \Phi$ of SBC is in inverse proportion to $R_d^{SBC}$. As a result, when SBC is connected to the preamplifier of a readout electronics with voltage noise $V_n$, the signal gain $(\partial i/\partial \Phi)_{SBC}$ for an external signal flux $\Delta\phi_e$ applied to SQUID loop is proportional to the noise contribution of preamplifier ($V_n/R_d^{SBC}$) and the signal-to-noise ratio SNR=$i_s/i_n$=[$\Delta\phi_e\cdot(\partial i/\partial \Phi)_{SB}$C]/($V_n/R_d^{SBC}$) keeps constant. In order to improve the SNR, there is a new readout scheme proposed, named "voltage biased SBC with two different equivalent resistances". Its readout electronics is shown in **Fig. 8**. The $(\partial i/\partial \Phi)_{SBC}$ is significantly increased which is described above, at the meanwhile the preamplifier noise contribution can be suppressed. Therefore, the SNR is greatly improved in contrast with the bare SQUID.

This readout electronics can be considered as two different equivalent circuits for preamplifier noise $V_n$(**Fig. 9a**) and the external flux signal $\Delta\phi_e$ (**Fig. 9b**), respectively. For the preamplifier noise source $V_n$, the equivalent circuit is similar to NC in **Fig. 3b**. The noise current through the inductance $L_{add}$ generates a flux in the SQUID loop via the mutual inductance $M_{add}$. This flux leads to a voltage $V_s$ across the SQUID. If the condition of

$$R_{add}=M_{add}\cdot\partial V/\partial \Phi$$

is fulfilled, $V_s$ is equal to the noise $V_n$, so that the noise current does not flow through the SQUID. Consequently, the noise current is kept as $V_n/R_{add}$, which is suppressed by $R_{add}/R_d$ ($R_{add}\geq R_d$) compared with the bare SQUID. With respect to the flux signal $\Delta\phi_e$, however, the equivalent circuit has been described above (see **Fig. 4b** or **Fig. 9b**). In this case, $(\partial i/\partial \Phi)_{SBC}$ is increased, so that SNR is improved further.

In Fig. 8 the coil (L) is connected to the first side of the SQUID (2); and an additional feedback path ($R_{add}$, $L_{add}$) is provided comprising an additional feedback coil ($L_{add}$) and an additional resistance ($R_{add}$) in series, being connected to the second side of the SQUID, whereby the additional Coil ($L_{add}$) is inductively coupled to the SQUID via an additional mutual inductance ($M_{add}$). Thereby the SQUID (2), the coils (L, $L_{add}$) and the resistance ($R_{add}$) form a two-terminal device with the first terminal ($T_1$) being electrically connected to that sides of the coil (L) and the feedback path ($L_{add}$, $R_{add}$), that are not connected with the SQUID and the second terminal ($T_2$) connected to the second side of the SQUID. This configuration with its terminals ($T_1$, $T_2$) can be connected or is connected to an readout electronic circuit, in particular a preamplifier, more in particular an OP, preferably being configured to operate as a current-voltage-converter, can be regarded as a novel two-terminal device.. It has to be noted that the coil (L) has an inverted polarity compared to the additional Coil ($L_{add}$). Thus, the second feedback path can being so designed and arranged that preamplifier noise can be reduced by the second feedback path.

The second feedback path($L_{add}$, $R_{add}$) and the SQUID are to be so designed and arranged that the mutual inductance ($M_{add}$) between the SQUID and the additional Feedback coil ($L_{add}$) follows the formula: $R_{add}=M_{add}\cdot\partial i/\partial\Phi$.

**Claims**

1. Sensor for detecting the magnetic flux, comprising a Direct-Current Superconducting Quantum Interference Device (dc SQUID) (2) and a feedback coil (4) electrically connected with a first side of the SQUID (2) and being inductively coupled to the SQUID via a mutual inductance (5, M)
   **characterized in that**
   the SQUID (2) and the coil (4, L) are connected in series, whereby the SQUID (2) is biased by an ideal voltage source (1), so that the SQUID (2) can be biased with a constant voltage.

2. Sensor according to claim 1, **characterized in that** the feedback coil (4, L) is arranged and designed as to operate as feedback coil.

3. Sensor according to claim 1 or 2, **characterized in that** the coil comprises a superconductor material as conductor, in particular a wire made of the same.

4. Sensor according to one of the previous claims, **characterized in that** the coil comprises a normal metal material, for example copper, as conductor, in particular a wire made of the same.

5. Sensor according to one of the previous claims, **characterized in that** the sensor comprises an integrated chip (IC) comprising the SQUID and the coil.

6. Sensor according to one of the previous claims, **characterized in that** the sensor comprises an integrated chip comprising the SQUID, whereby the coil is placed separately next to the SQUID.

7. Sensor according to one of the previous claims, **characterized in that** a flat spiral coil or spring coil forms the coil (4, L) and is arranged above the SQUID.

8. Sensor according to one of the previous claims, **characterized in that** an insulating intermediate layer is provided between the coil and the SQUID.

9. Sensor according to one of the previous claims, **characterized in that** the SQUID (2) and the coil (4) form a two-terminal device with the first terminal ($T_1$) being electrically connected to the first side of the SQUID, one side of the coil being electrically connected to the second side of the SQUID and an other side of the coil being electrically connected to the second terminal ($T_2$).

10. Sensor according to one of the previous claims, **characterized in that** the feedback coil (4) and the SQUID (2) are so designed and arranged that the *I*-$\Phi$ characteristics of the sensor are asymmetric.

11. Sensor according to one of the previous claims, **characterized in that** the feedback coil (4, L) and the SQUID (2) are so designed and arranged that the mutual inductance (5, M) follows the following formula:

$$(\partial i/\partial\Phi)_{SBC} = (\partial i/\partial\Phi)/(1-M\cdot\partial i/\partial\Phi) = \ X, \text{ whereby}$$

- $(\partial i/\partial\Phi)_{SBC}$ is the current-to-flux transfer coefficient of a SQUID (2) with the coil (4,L) according to one of the previous claims;
- $\partial i/\partial\Phi$ is the current-to-flux transfer coefficient of a bare SQUID without the coil (4,L);
- $M^2 = k^2(Ls\ L)$, with

  - k being the coupling coefficient between the SQUID and the coil;
  - L being the inductance of the feedback coil and
  - Ls being the inductance of the SQUID,

- whereby X is between 0 and 1,1, preferably between 0,5 and 1, and more preferably between 0,84 and 0,96.

12. Sensor according to one of the previous claims, **characterized in that** the coil (L) is connected to the first side of the SQUID (2); and

    an additional feedback path ($R_{add}$, $L_{add}$) is provided comprising an additional feedback coil ($L_{add}$) and an additional resistance ($R_{add}$) in series, being connected to the second side of the SQUID,

    whereby the additional Coil ($L_{add}$) is inductively coupled to the SQUID via an additional mutual inductance ($M_{add}$)

13. Sensor according to claim 12, **characterized in that** the SQUID (2), the coils (L, $L_{add}$) and the resistance ($R_{add}$) form a two-terminal device with the first terminal ($T_1$) being electrically connected to that sides of the coil (L) and the feedback path ($L_{add}$, $R_{add}$) in series, that are not connected with the SQUID and the second terminal ($T_2$) connected to the second side of the SQUID.

14. Sensor according to one of the previous claims 12 or 13, **characterized in that** the coil (L) has an inverted polarity compared to the additional Coil ($L_{add}$)

15. Sensor according to one of the previous claims 12-14, **characterized in that** the second feedback path being so designed and arranged that preamplifier noise can be reduced by the second feedback path.

16. Sensor according to one of the previous claims 12-15, **characterized in that** the second feedback path($L_{add}$, $R_{add}$) and the SQUID being so designed and arranged that the mutual inductance ($M_{add}$) between the SQUID and the additional Feedback coil ($L_{add}$) follows the following formula:

$$R_{add}=M_{add} \cdot \partial V/\partial \Phi,$$

wherein

- $\partial i/\partial \Phi$ is the flux-to-voltage transfer coefficient of SQUID; and
- $M_{add}^2 = k_{add}^2 (Ls\ L_{add})$, with

    - $k_{add}$ being the coupling coefficient between SQUID and the additional coil ($L_{add}$);
    - $L_{add}$ being the inductance of the additional feedback coil ($L_{add}$) and
    - Ls being the inductance of the SQUID,

17. Sensor according to claim 9 or 13, **characterized in that** the sensor further comprises or is connected with its terminals ($T_1$, $T_2$) to an readout electronic circuit, in particular a preamplifier, more in particular an OP, preferably being configured to operate as a current-voltage-converter.

18. Sensor according to claim 9 or 13, **characterized in that** the two-terminal device being designed on an integrated chip (IC).

**Patentansprüche**

1. Sensor zum Nachweis des magnetischen Flusses, umfassend eine supraleitende Gleichstrom-Quanten-Interferenz-Vorrichtung (dcSQUID) (2) und eine Rückkopplungsspule (4), die mit einer ersten Seite des SQUID (2) elektrisch verbunden ist und die mit dem SQUID über gegenseitige Induktanz (5, M) induktiv gekoppelt wird

    **dadurch gekennzeichnet, dass**

    der SQUID (2) und die Spule (4, L) in Serie verbunden sind, wobei der SQUID (2) mit einer idealen Vorspannungsquelle (1) beaufschlagt wird, so dass der SQUID (2) mit einer konstanten Vorspannung beaufschlagt werden kann.

2. Sensor nach Anspruch 1, **dadurch gekennzeichnet, dass** die Rückkopplungsspule (4, L) angeordnet und konstruiert ist, so dass sie als Rückkopplungsspule arbeitet.

3. Sensor nach Anspruch 1 oder 2, **dadurch gekennzeichnet, dass** die Spule (4, L) als Leiter ein supraleitendes Material umfasst, insbesondere einen aus demselben hergestellten Draht.

4. Sensor nach einem der vorhergehenden Ansprüche, **dadurch gekennzeichnet, dass** die Spule ein normales Metallmaterial umfasst, beispielsweise Kupfer, als Leiter, insbesondere einen aus demselben hergestellten Draht.

5. Sensor nach einem der vorhergehenden Ansprüche, **dadurch gekennzeichnet** der Sensor einen integrierten Chip (IC) umfasst, der den SQUIDD und die Spule umfasst.

6. Sensor nach einem der vorhergehenden Ansprüche, **dadurch gekennzeichnet, dass** der Sensor einen integrierten Chip umfasst, der den SQUID einschließt, wodurch die Spule separat in der Nähe des SQUID angeordnet ist.

7. Sensor nach einem der vorhergehenden Ansprüche, **dadurch gekennzeichnet, dass** eine flache Spiralspule oder Federspule die Spule (4, L) formt und oberhalb des SQUID angeordnet ist.

8. Sensor nach einem der vorhergehenden Ansprüche, **dadurch gekennzeichnet, dass** eine isolierende Zwischenschicht zwischen der Spule und dem SQUID bereitgestellt ist.

9. Sensor nach einem der vorhergehenden Ansprüche, **dadurch gekennzeichnet, dass** der SQUID (2) und die Spule (4) eine zweidimensionale Vorrichtung bilden, wobei der erste Ausgang ($T_1$) mit der ersten Seite des SQUID elektrisch verbunden ist, wobei eine Seite der Spule mit der zweiten Seite des SQUID elektrisch verbunden ist und eine andere Seite der Spule mit dem zweiten Ausgang ($T_2$) elektrisch verbunden ist.

10. Sensor nach einem der vorhergehenden Ansprüche, **dadurch gekennzeichnet, dass** die Rückkopplungsspule (4) und der SQUID (2) so aufgebaut und angeordnet sind, dass die $I$-$\Phi$-Charakteristika des Sensors asymmetrisch sind.

11. Sensor nach einem der vorhergehenden Ansprüche, **dadurch gekennzeichnet, dass** die Rückkopplungsspule (4, L) und der SQUID (2) so aufgebaut und angeordnet sind, dass die gegenseitige Induktanz (5, M) der folgenden Formel folgt:

$$(\partial i/\partial \Phi)_{SBC} = (\partial i/\partial \Phi)/(1-M \cdot \partial i/\partial \Phi) = X,$$

wobei
$(\partial i/\partial \Phi)_{SBC}$ der Strom-zu-Fluss-Transferkoeffizient eines SQUID (2) mit der Spule (4, L) nach einem der der vorhergehenden Ansprüche ist, $(\partial i/\partial \Phi)$ der Strom-zu-Fluss-Transferkoeffizient eines reinen SQUID (2) ohne die Spule (4, L) ist,

$$M2 = k^2(LsL),$$

wobei

- k der Kopplungskoeffizient zwischen dem SQUID und der Spule ist;
- L die Induktanz der Rückkopplungsspule ist und
- Ls die Induktanz des SQUID ist,

wobei X zwischen 0 und 1,1 vorzugsweise zwischen 0,5 und 1 liegt, und stärker bevorzugt zwischen 0,84 und 0,96 liegt.

12. Sensor nach einem der vorhergehenden Ansprüche, **dadurch gekennzeichnet, dass** die Spule (L) mit der ersten Seite des SQUID (2) verbunden ist, und
ein zusätzlicher Rückkopplungspfad ($R_{add}$, $L_{add}$) bereitgestellt ist, umfassend eine zusätzliche Rückkopplungsspule ($L_{add}$) und einen zusätzlichen Widerstand ($R_{add}$) in Serie, die mit der zweiten Seite des SQUID verbunden sind, wobei die zusätzliche Spule ($L_{add}$) induktiv mit dem SQUID über eine zusätzliche gegenseitige Induktanz ($M_{add}$) induktiv gekoppelt ist.

13. Sensor nach Anspruch 12, **dadurch gekennzeichnet, dass** der SQUID (2) die Spulen (L, $L_{add}$) und der Widerstand

($R_{add}$) eine zweidimensionale Vorrichtung bilden, wobei der erste Ausgang (T1) elektrisch mit den Seiten der Spule (L) und dem Rückkopplungsweg ($L_{add}$, $R_{add}$) in Serie verbunden ist, die nicht mit dem SQUID verbunden sind, und der zweite Ausgang ($T_2$) mit der zweiten Seite des SQUID verbunden ist.

**14.** Sensor nach einem der vorhergehenden Ansprüche 12 oder 13, **dadurch gekennzeichnet, dass** die Spule (L) eine umgekehrte Polarität im Vergleich zu der zusätzlichen Spule ($L_{add}$) aufweist.

**15.** Sensor nach einem der vorhergehenden Ansprüche 12-14, **dadurch gekennzeichnet, dass** der zweite Rückkopplungspfad so aufgebaut und angeordnet ist, dass das Vorverstärkerrauschen durch den zweiten Rückkopplungspfad vermindert werden kann.

**16.** Sensor nach einem der vorhergehenden Ansprüche 12-15, **dadurch gekennzeichnet, dass** der zweite Rückkopplungspfad ($R_{add}$, $L_{add}$) und der SQUID so aufgebaut und angeordnet sind, dass die gegenseitige Induktanz ($M_{add}$) zwischen dem SQUID und der zusätzlichen Rückkopplungsspule ($L_{add}$) der folgenden Formel gehorchen:

$$R_{add} = M_{add} \cdot \partial V / \partial \Phi,$$

wobei

- $\partial i / \partial \Phi$ der Fluss-zu-Spannungstransferkoeffizient des SQUID ist; und
- $M_{add}^2 = k_{aad}^2 (LSL_{add})$, wobei
- $k_{add}$ der Kopplungskoeffizient zwischen dem SQUID und der zusätzlichen Spule ($L_{add}$) ist;
- $L_{add}$ die Induktanz ist der zusätzlichen Rückkopplungsspule ($L_{add}$) ist und
- Ls die Induktanz des SQUID ist.

**17.** Sensor nach Anspruch 9 oder 13, **dadurch gekennzeichnet, dass** der Sensor weiterhin seine Ausgänge ($T_1$, $T_2$) umfasst oder mit ihnen zu einem elektronischen Auslesekreis zusammengeschlossen ist, insbesondere zu einem Vorverstärker, spezieller einem OP, der vorzugsweise konfiguriert ist, um als Strom-zu-Spannungs-Wandler zu arbeiten.

**18.** Sensor nach Anspruch 9 oder 13, **dadurch gekennzeichnet, dass** die zweidimensionale Vorrichtung auf einem integrierten Chip (IC) aufgebaut ist.

## Revendications

**1.** Capteur pour la détection du flux magnétique, comprenant un dispositif d'interférence quantique supraconducteur à courant continu (SQUID) (2) et une bobine de rétroaction (4), qui est connectée électriquement à un premier côté du SQUID (2) et qui est couplée au SQUID par une inductance mutuelle (5, M)
**caractérisé par le fait que**
le SQUID (2) et la bobine (4, L) sont connectés en série, le SQUID (2) étant biaisé avec une source de tension idéale (1) tel que le SQUID (2) peut être biaisé avec une tension constante.

**2.** Capteur selon la revendication 1, **caractérisé par le fait que** la bobine de rétroaction (4, L) est arrangée et construite tel qu'elle est mis en oeuvre à titre de bobine de rétroaction.

**3.** Capteur selon la revendication 1 ou 2, **caractérisé par le fait que** la bobine comprend un matériau supraconducteur à tire de conducteur (4, L) particulièrement un fil de fer fabriqué de celui-ci.

**4.** Capteur selon l'une des revendications précédentes, **caractérisé par le fait que** la bobine comprend un matériau de métal normal, par exemple du cuivre, à titre de conducteur, particulièrement un fil de fer fabriqué de celui-ci.

**5.** Capteur selon l'une des revendications précédentes, **caractérisé par le fait que** le capteur comprend une puce intégré comprenant le SQUID et la bobine.

6. Capteur selon l'une des revendications précédentes, **caractérisé par le fait que** le capteur comprend une puce intégrée qui comprend le SQUID, la bobine étant arrangée séparément à côté du SQUID.

7. Capteur selon l'une des revendications précédentes, **caractérisé par le fait qu'**une bobine spirale plate ou un ressort hélicoïdal forme la bobine (4, L) et est arrangé au-dessus du SQUID.

8. Capteur selon l'une des revendications précédentes, **caractérisé par le fait qu'**une couche intermédiaire isolante est fournie entre la bobine et le SQUID.

9. Capteur selon l'une des revendications précédentes, **caractérisé par le fait que** le SQUID (2) et la bobine (4) forment un dispositif en deux dimensions le premier terminal ($T_1$) étant connecté électriquement avec le premier côté du SQUID, un côté de la bobine étant connecté électriquement au deuxième côté du SQUID et un autre côté de la bobine étant connecté électriquement au deuxième terminal (T2).

10. Capteur selon l'une des revendications précédentes, **caractérisé par le fait que** la bobine de rétroaction (4) et le SQUID (2) sont arrangés est construits tel que le caractéristiques $I$-$\Phi$ du capteur sont asymétriques.

11. Capteur selon l'une des revendications précédentes, **caractérisé par le fait que** la bobine de rétroaction (4, L) et le SQUID (2) sont arrangés est construits tel que l'inductance mutuelle (5, M) satisfait la formule suivante:

$$(\partial i/\partial \Phi)_{SBC} = (\partial i/\partial \Phi)/(1-M \cdot \partial i/\partial \Phi) = X,$$

dans lequel
$(\partial i/\partial \Phi)_{SBC}$ est le coefficient de transfert courant-flux d'un SQUID (2) avec la bobine (4, L) selon l'une des revendications précédentes,
$(\partial i/\partial \Phi)$ est le coefficient de transfert courant-flux d'un SQUID (2) brut dépourvu de la bobine (4, L),
$M^2 = k^2(LsL)$, dans lequel

   - k est le coefficient de couplage entre le SQUID et la bobine;
   - L est l'inductance de la bobine de rétroaction et
   - Ls est l'inductance du SQUID,

X étant entre 0 et 1,1 préférablement entre 0,5 et 1 et plus préférablement entre 0,84 et 0,96.

12. Capteur selon l'une des revendications précédentes, **caractérisé par le fait que** la bobine (L) est connecté électriquement au premier côté du SQUID (2), et
un chemin de rétroaction additionnel ($R_{add}$, $L_{add}$) est fourni, comprenant une bobine de rétroaction additionnelle ($L_{add}$) et une résistance additionnel ($R_{add}$) en série, étant connectés au deuxième côté du SQUID,
dans lequel la bobine additionnelle ($L_{add}$) est couplée inductivement avec le SQUID par une inductance mutuelle ($M_{add}$).

13. Capteur selon la revendication 12, **caractérisé par le fait que** le SQUID (2), les bobines (L, $L_{add}$) et la résistance ($R_{add}$) forment un dispositif en deux dimensions, le premier terminal (T1) étant électriquement connecté en série aux côtés de la bobine (L) et du chemin de rétroaction ($L_{add}$, $R_{add}$), qui ne sont pas connectés au SQUID, et le deuxième terminal ($T_2$) est connecté au deuxième côté du SQUID.

14. Capteur selon l'une des revendications précédentes 12 ou 13, **caractérisé par le fait que** la bobine (L) a une polarité inverse en comparaison à la bobine additionnelle ($L_{add}$).

15. Capteur selon l'une des revendications précédentes 12-14, **caractérisé par le fait que** le deuxième chemin de rétroaction est construit et arrangé tel que les interférences d'un préamplificateur peuvent être réduites par le deuxième chemin de rétroaction.

16. Capteur selon l'une des revendications précédentes 12-15, **caractérisé par le fait que** le deuxième chemin de rétroaction ($R_{add}$, $L_{add}$) et le SQUID sont construits et arrangés tel que l'inductance mutuelle ($M_{add}$) entre le SQUID et la bobine de rétroaction additionnelle ($L_{add}$) satisfait la formule suivante:

$$R_{add} = M_{add} \cdot \partial V / \partial \Phi,$$

dans lequel

$\partial i / \partial \Phi$ est le coefficient de transfert courant-flux du SQUID est; et

- $M_{add}^2 = k_{add}^2(LsL_{add})$, avec
- $k_{add}$ étant le coefficient de couplage entre le SQUID et la bobine additionnelle ($L_{add}$);
- L étant l'inductance de la bobine de rétroaction additionnelle et
- Ls étant l'inductance du SQUID.

**17.** Capteur selon la revendication 9 ou 13, **caractérisé par le fait que** le capteur comprend en outre ou est connecté avec ses terminaux ($T_1$, $T_2$) à un circuit d'affichage électronique, particulièrement un préamplificateur, plus particulièrement un OP, préférablement étant configuré pour l'opération à titre d'un transformateur courant-tension.

**18.** Capteur selon la revendication 9 ou 13, **caractérisé par le fait que** le dispositif en deux dimensions est sur une puce intégré (IC).

## Fig. 1a:

a)

## Fig. 1b:

b)

## Fig. 2:

$V$ (i)

$\Delta v$
$(\Delta i)$

$\Phi_0$

$\phi_e$

## Fig. 3a:

a)

M

## Fig. 3b:

b)

M

FET

## Fig. 4a:

## Fig. 4b:

## Fig. 5a:

## Fig. 5b:

## Fig. 6a - d:

## Fig. 7a - d:

14

## Fig. 8

## Fig. 9a:

## Fig. 9b:

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 07318623 A

- JP 8146109 A


### Non-patent literature cited in the description

- **R. L. FORGACS et al.** Digital-analog magnetometer utilizing superconducting sensor. *Rev. Sci. Instrum.,* 1967, vol. 38, 214-220
- **M. GERSHENSON.** Design of a hysteretic SQUID as the readout for a dc-SQUID. *IEEE Trans. Magn.,* 1991, vol. 27, 2910-2912
- **M. PODT et al.** Two-stage amplifier based on a double relaxation oscillation superconducting quantum interference device. *Appl. Phys. Lett.,* 1999, vol. 75, 2316-2318
- **D. DRUNG et al.** Measured performance parameters of gradiometers with digital output. *IEEE trans.Magn.,* 1989, vol. 25, 1034-1037
- **F. C. WELLSTOOD et al.** Low-frequency noise in dc superconducting quantum interference devices below 1 K. *Appl. Phys. Lett.,* 1987, vol. 50, 772-774
- **V. FOGLIETTI.** Double dc-SQUID for flux-locked-loop operation. *Appl. Phys. Lett,* 1991, vol. 59, 476-478
- **MASLENNIKOV et al.** A double dc-SQUID based magnetometer. *IEEE Trans. Appl. Supercond.,* 1995, vol. 5, 3241-3243
- **R. P. WELTY et al.** Two-stage integrated SQUID amplifer with series array output. *IEEE Trans. Appl. Supercond.,* 1993, vol. 3, 2605-2608
- **R. P. WELTY et al.** A series array of dc-SQUIDs. *IEEE Trans. Magn.,* 1991, vol. 27, 2924-2926
- **F.L. VERNON et al.** Relaxation oscillations in Josephson junctions. *J. Appl. Phys.,* 1968, vol. 39, 2661-2664
- **D. J. ADELERHOF et al.** Double) relaxation oscillation SQUIDs with high flux-to-voltage transfer: simulations and experiments. *J. Appl. Phys.,* 1994, vol. 76, 3875-3886
- **D. DRUNG et al.** Low-noise high-speed dc superconducting quantum interference device magnetometer with simplified feedback electronics. *Appl. Phys. Lett.,* 1990, vol. 57, 406-408
- **D. DRUNG.** *Supercond. Sci. Technol.,* 2003, vol. 16, 1320-1336
- **M. KIVIRANTA et al.** DC-SQUID electronics based on the noise cancellation scheme. *IEEE Trans. Appl. Supercond.,* 1995, vol. 5, 2146-2148
- **H. SEPPÄ et al.** *IEEE Trans. Magn.,* 1991, vol. 27, 2488-2490
- SQUID linearization by current-sampling feedback. **MIKKO KIVIRANTA.** Superconductor Science and Technology. IOP Publishing, 01 April 2008, vol. 21, 45009